Europäisches Patentamt

European Patent Office

Office européen des brevets

(19)

(11) Veröffentlichungsnummer: **0 234 021 B1**

# EUROPÄISCHE PATENTSCHRIFT

(12)

(45) Veröffentlichungstag der Patentschrift: **18.12.91**

(51) Int. Cl.5: **H01L 23/46**

(21) Anmeldenummer: **86117249.2**

(22) Anmeldetag: **11.12.86**

(54) **Vorrichtung für eine Flüssigkeitskühlung eines elektrischen Bauelementes, insbesondere Halbleiter-Bauelementes.**

(30) Priorität: **16.01.86 DE 3601140**
**01.12.86 DE 8632161 U**

(43) Veröffentlichungstag der Anmeldung:
**02.09.87 Patentblatt 87/36**

(45) Bekanntmachung des Hinweises auf die Patenterteilung:
**18.12.91 Patentblatt 91/51**

(84) Benannte Vertragsstaaten:
**CH DE FR GB IT LI NL SE**

(56) Entgegenhaltungen:
**EP-A- 0 142 678**
**CH-A- 319 751**
**DE-B- 1 295 090**
**US-A- 4 010 489**
**US-A- 4 142 577**

(73) Patentinhaber: **SIEMENS AKTIENGESELL-SCHAFT**
**Wittelsbacherplatz 2**
**W-8000 München 2(DE)**

(72) Erfinder: **Düll, Hans-Jürgen, Dipl.-Ing. (FH)**
**Fichtenstrasse 13**
**W-8521 Langensendelbach(DE)**
Erfinder: **Kaiser, Hans, Dipl.-Ing.**
**Friedrich-Bauer-Strasse 33**
**W-8520 Erlangen(DE)**

**Beschreibung**

Die Erfindung betrifft eine Vorrichtung zur Flüssigkeitskühlung eines elektrischen Bauelementes.

Bei einem Halbleiter-Gleichrichtergerät mit einer Reihenparallelschaltung von Gleichrichterzellen ist es aus der DE-C-12 08 008 bekannt, je eine Gleichrichterzelle an einem Klemmstück anzubringen und zur Verbindung der Gleichrichterzellen jeder Reihe untereinander die Klemmstücke unter Verwendung von Gegenstücken auf zwei wasserdurchflossenen metallenen Kühlrohren unter Zwischenlage dünner Isolierschichten aufzureihen. Bei dieser Ausführung ist ein guter Wärmeübergang vom Klemmstück zur Isolierschicht und von dort zum Kühlrohr nur bei einer exakten Anpassung der isolierten zylinderförmigen Aussparungen der Klemmstücke an den Außendurchmesser der Kühlrohre gewährleistet.

Durch das DE-U-75 39 808 ist eine Vorrichtung zur Flüssigkeitskühlung von elektrischen Bauteilen bekannt, bei der zur Potentialtrennung zwischen den elektrischen Bauteilen und der Kühlflüssigkeit ein selbsttragendes, elektrisch isolierendes Rohr vorgesehen ist, das von der Kühlflüssigkeit durchströmt wird. Auf dem Rohr sind die die elektrischen Bauteile tragenden Kühlkörper schellenartig befestigt.

Bei einer solchen Verbindung der Kühlkörper mit dem die Kühlflüssigkeit führenden Rohr ergibt sich zwangsläufig ein hoher Wärmeübergangswiderstand zwischen den Kühlkörpern und der Wand des Rohres, da infolge von Fertigungsungenauigkeiten kein sattes Anliegen des Kühlkörpers mit seiner ganzen Fläche erreichbar ist. Außerdem bedeutet das Anbringen der Kühlkörper an dem Rohr einen zusätzlichen Fertigungsaufwand.

Ferner ist aus dem DE-U 75 39 365 eine Halbleiter-Gleichrichteranordnung bekannt, bei der auf einer mit Kühlkanälen versehenen Kontaktplatte thermisch gut leitende Isolierstoffscheiben angeordnet sind, an der ungekapselte Gleichrichterelemente befestigt sind.

Aus der CH-PS 319 751 ist eine Kühlvorrichtung bekannt, welche aus einem Kühlkörper mit einem Unter- und Oberteil besteht. In einem darin befindlichen, mäanderartigen Gang ist ein Schlauch aus elektrisch isolierendem und wärmeleitenden Material, insbesondere aus Gummi, eingelegt. Der Schlauch hat im Wesentlichen die Aufgabe, die Lebensdauer der Anordnung herabzusetzende Korrosionserscheinungen im Kühlmittelkreislauf zu unterbinden, welche von Potentialdifferenzen hervorgerufen werden.

Gegenüber diesem Stand der Technik liegt der Erfindung die Aufgabe zugrunde, sowohl eine größere Einfachheit im Aufbau einer Vorrichtung zur Flüssigkeitskühlung elektrischer Bauelemente zu erzielen, als auch den Wärmeübergang zwischen Kühlkörper und Kühlflüssigkeit zu verbessern.

Diese Aufgabe wird erfindungsgemäß durch die in Anspruch 1 enthaltene Vorrichtung gelöst.

Weitere Ausführungsformen der Erfindung sind in den Unteransprüchen enthalten.

Die Erfindung hat den Vorteil, daß durch die Verwendung eines selbsttragenden Isolierkörpers der Wärmeübergang zwischen dem Isolierkörper und dem Kühlkörper verbessert und der Fertigungsaufwand vermindert wird.

Durch die Erfindung wird gegenüber den bekannten Ausführungen, bei denen Wärme zwischen aneinandergepreßten Teilen übertragen wird, der Wärmeübergang wesentlich verbessert, da im Übertragungsweg Luftschichten vollständig vermieden und der Wärmeübertragungsweg selbst kleingehalten werden kann. Die Vorrichtung bildet ein kompaktes Bauelement, das unempfindlich gegen äußere Einwirkungen bei der Montage, bei der Wartung und im Betrieb ist.

Eine hohlraumfreie Verbindung zwischen dem Kühlkörper und dem selbsttragenden Isolierkörper wird fertigungstechnisch auf einfache Weise dadurch erreicht, daß der Kühlkörper durch Spritzen oder Gießen mit dem Isolierkörper verbunden ist.

Ein allen Anforderungen im Hinblick auf Dichtigkeit, elektrische Isolationsfähigkeit, gute Wärmeleitfähigkeit und gute Verbindbarkeit mit dem Metall des Kühlkörpers entsprechende Vorrichtung ist dadurch gekennzeichnet, daß als Isolierkörper ein aus Bornitrid-Keramik gefertigter plattenförmiger Hohlkörper vorgesehen ist.

Eine große Wärmeübertrittsfläche wird nach einer weiteren Ausgestaltung der Erfindung dadurch erzielt, daß in dem Hohlraum des Hohlkörpers an zwei gegenüberliegenden Seiten durch Wandungen jeweils ein Längskanal gebildet ist, von denen der eine mit einer Kühlmittelzuführleitung und der andere mit einer Kühlmittelrückführleitung verbunden ist, daß ferner in dem Hohlraum die beiden Längskanäle verbindende Querkanäle vorgesehen sind.

Die Wärmeübertrittsfläche kann noch dadurch vergrößert werden, daß zwischen den Querkanälen parallel zu den Längskanälen verlaufende Verbindungskanäle vorgesehen sind.

Besonders vorteilhaft ist es, zwei gegenüberliegende Seiten des Kühlkörpers als Kontaktflächen für druckkontaktierte Halbleiter-Bauelemente auszubilden. Dabei kann der Kühlkörper bei Verwendung einer elektrisch leitenden Kühlflüssigkeit als Stromzuführung dienen. Bei Verwendung von Leitungswasser als Kühlflüssigkeit können Entionisierungsanlagen eingespart werden.

Ausführungsbeispiele der Erfindung sind in der Zeichnung dargestellt. Darin zeigen:

FIG 1       eine Baugruppe aus beidseitig gekühlten, druckkontaktierten Halbleiter-Bauelementen,

FIG 2    eine Vorrichtung im Schnitt, bei der der Isolierkörper als einfaches Rohr und

FIG 3    eine andere Vorrichtung im Schnitt, bei der der Isolierkörper als plattenförmiger Hohlkörper ausgebildet ist, und

FIG 4    die Vorrichtung von Fig. 3 im Schnitt entlang der Linie VII-VII.

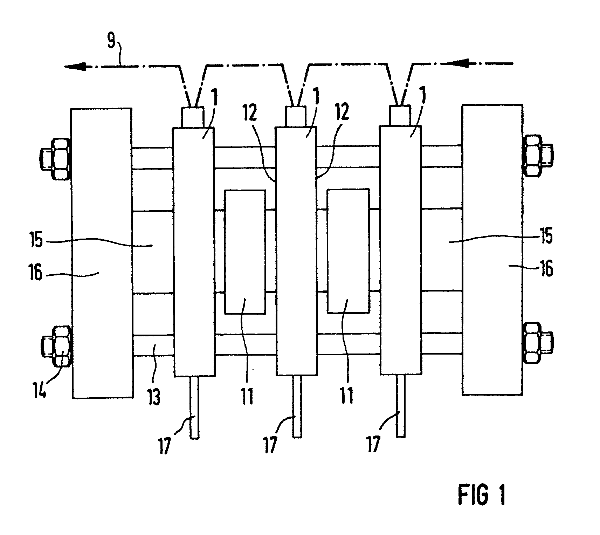

Die in FIG 1 gezeigte Baugruppe besteht aus zwischen Kühlkörpern 1 angeordneten zweiseitig gekühlten, druckkontaktierten Halbleiter-Bauelementen 11. Hierbei sind jeweils zweieinander gegenüberliegende Seiten 12 der Kühlkörper 1 als Kontaktfläche für die druckkontaktierten Halbleiter-Bauelemente 11 ausgebildet. Die Halbleiter-Bauelemente und Kühlkörper werden durch Spannelemente zusammengehalten, die aus Spannschrauben 13 und Muttern 14 sowie aus Druckstücken 15 und Spannbügeln 16 bestehen.

Die Kühlkörper 1 dienen zugleich als Stromschienen, die mit Anschlußfahnen 17 versehen sind.

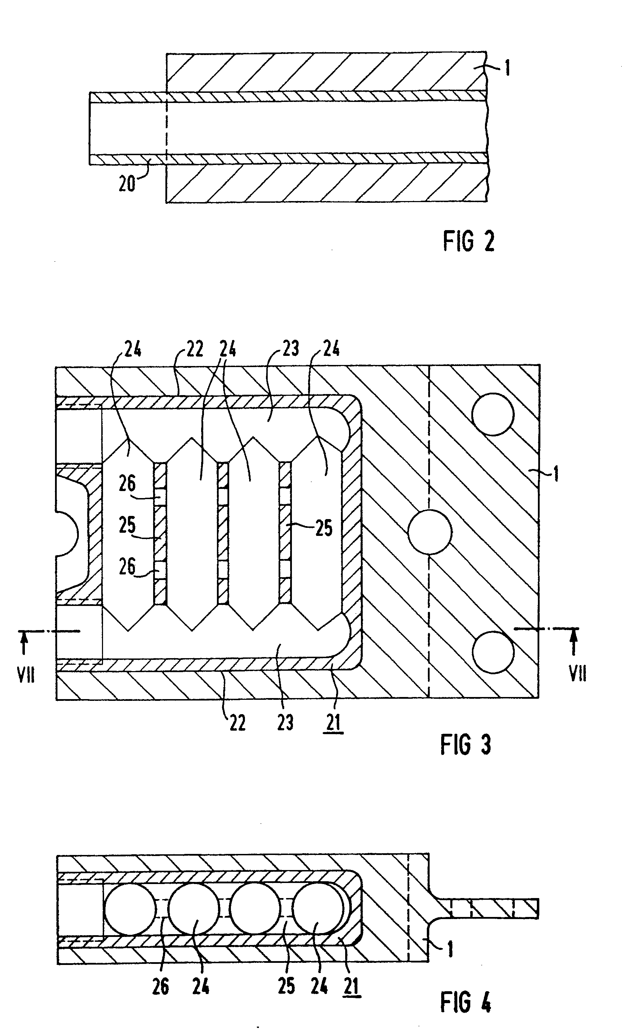

Mit 1 ist auch in den FIG 2-4 jeweils ein Kühlkörper aus Metall bezeichnet, auf dem die zu kühlenden elektrischen oder elektronischen Bauelemente direkt ohne Zwischenfügen einer Isolierschicht angeordnet werden. Ein aus elektrisch isolierendem, jedoch gut wärmeleitendem Material bestehendes Rohr 20 ist mit dem Kühlkörper 1 hohlraumfrei verbunden. Hierdurch ergibt sich ein guter Wärmeübergang zwischen dem Rohr 20 und dem Kühlkörper 1, der den auf ihm angeordneten Bauelementen die Wärme entzieht. An das Rohr 20 werden die Kühlmittelleitungen angeschlossen, die das das Rohr 20 durchströmende Kühlmittel zu- und abführen.

Bei dem in FIG 3 und 4 dargestellen Ausführungsbeispiel ist der von dem Kühlmittel durchströmte Isolierkörper als plattenförmiger Hohlkörper 21 ausgebildet. parallel zu jeder Längsseite 22 des Hohlkörpers 21 ist jeweils ein Längskanal 23 ausgebildet. An dem einen Längskanal 23 wird eine das Kühlmittel zuführende und an den anderen Längskanal 23 eine das Kühlmittel rückführende Leitung angeschlossen. Zwischen den beiden Längskanälen 23 sind diese miteinander verbindende Querkanäle 24 vorgesehen. In den Wandungen 25 der Querkanäle 24 sind nochmals Verbindungskanäle 26 angeordnet, durch die die Wärmeübertrittsfläche zwischen dem Hohlkörper 21 und der diesen durchströmenden Kühlflüssigkeit noch vergrößert wird.

Der selbsttragende Isolierkörper in Form eines Rohres 20 oder eines plattenförmigen Hohlkörpers 21 wird mit dem metallischen Kühlkörper umgossen oder umspritzt. Hierdurch wird auch bei Verwendung von selbsttragenden Isolierkörpern eine hohlraumfreie Verbindung zwischen diesen und dem Kühlkörper 1 erreicht. Als selbsttragende Isolierkörper haben sich insbesondere solche aus Bornitrid-Keramik gut bewährt. Da diese Keramikart flüssigkeitsdicht ist, ferner eine hohe Wärmeleitfähigkeit besitzt und spanabhebend bearbeitbar ist sowie die gute elektrische Isolationsfähigkeit der Keramiken aufweist, erfüllt sie alle Anforderungen, die an einen solchen Isolierkörper gestellt werden.

## Patentansprüche

1. Vorrichtung zur Flüssigkeitskühlung eines elektrischen Bauelementes, welches elektrisch und thermisch leitend an einem einteilig ausgebildeten Kühlkörper (1) angeordnet ist, der mit mindestens einem selbsttragenden, von Kühlflüssigkeit durchströmten, elektrischen Isolierkörper (20 bzw. 21) wärmeleitfähig und diesen umfassend hohlraumfrei verbunden ist, und an den Kühlmittelleitungen elektrisch isoliert angeschlossen sind.

2. Vorrichtung nach Anspruch 1, **dadurch gekennzeichnet,** daß der Kühlkörper (1) durch Spritzen oder Gießen mit dem Isolierkörper (20 bzw.21) verbunden ist.

3. Vorrichtung nach Anspruch 1 oder 2, **dadurch gekennzeichnet,** daß als Isolierkörper ein aus Bornitrid-Keramik gefertigter plattenförmiger Hohlkörper (21) vorgesehen ist.

4. Vorrichtung nach Anspruch 3, **dadurch gekennzeichnet,** daß in dem Hohlraum des Hohlkörpers (21) an zwei gegenüberliegenden Seiten durch Wandungen jeweils ein Längskanal (23) gebildet ist, von denen der eine mit einer Kühlmittelzuführleitung und der andere mit einer Kühlmittelrückführleitung verbunden ist, daß ferner in dem Hohlraum die beiden Längskanäle (23) verbindende Querkanäle (24) vorgesehen sind.

5. Vorrichtung nach Anspruch 4, **dadurch gekennzeichnet,** daß zwischen den Querkanälen (24) parallel zu den Längskanälen (23) verlaufende Verbindungskanäle (26) vorgesehen sind.

6. Vorrichtung nach einem der vorangegangenen Ansprüche, **dadurch gekennzeichnet,** daß zwei einander gegenüberliegende Seiten (12) des Kühlkörpers (1) als Kontaktierflächen für durchkontaktierte Halbleiter-Bauelemente (11) ausgebildet sind.

## Claims

1. Liquid cooling device for an electrical component, which is disposed in an electrically and thermally conductive manner on a one-piece cooling body (1) which is connected without cavities and in heat-conductive manner to at least one self-supporting electrical insulating body (20 or 21) through which coolant flows, and enclosing the latter, and to which coolant lines are connected in an electrically insulating manner.

2. Device according to claim 1, characterised in that the cooling body (1) is connected by injection or casting to the insulating body (20 or 21).

3. Device according to claim 1 or 2, characterised in that a plate-shaped hollow body (21) made of boron nitride ceramics is provided as an insulating body.

4. Device according to claim 3, characterised in that in the cavity of the hollow body (21) a longitudinal duct (23) is respectively formed by walls on two opposite sides, one of which ducts is connected to a coolant supply line and the other to a coolant return line, and in that transverse ducts joining the two longitudinal ducts (23) are also provided in the cavity.

5. Device according to claim 4, characterised in that between the transverse ducts (24) there are provided connecting ducts (26) which extend parallel to the longitudinal ducts (23).

6. Device according to one of the preceding claims, characterised in that two opposite sides (12) of the cooling body (1) are formed as contacting surfaces for through-connected semi-conductor components (11).

**Revendications**

1. Dispositif pour refroidir un liquide d'un composant électrique qui est disposé à conduction électrique et thermique sur un dissipateur de chaleur (1) réalisé d'un seul tenant et qui est relié selon une liaison thermoconductrice à au moins un corps isolant électrique autoportant (20 ou 21), parcouru par un liquide de refroidissement, et de manière à entourer le corps sans laisser subsister aucune cavité, et auquel des canalisations du milieu de refroidissement sont raccordées d'une manière isolée électriquement.

2. Dispositif suivant la revendication 1, caractérisé par le fait que le dissipateur de chaleur (1) est raccordé au corps isolant (20 ou 21) par moulage par injection ou par coulée.

3. Dispositif suivant la revendication 1 ou 2, caractérisé par le fait qu'il est prévu, en tant que corps isolant, un corps creux (21) en forme de plaque, réalisé en une céramique à base de nitrure de bore.

4. Dispositif suivant la revendication 3, caractérisé par le fait que dans la cavité du corps (21) sont ménagés respectivement, à travers des parois, et ce sur les deux côtés opposés, des canaux longitudinaux respectifs (23), dont l'un est raccordé à une canalisation d'amenée du milieu de refroidissement et dont l'autre est raccordé à une canalisation de renvoi du milieu de refroidissement et qu'il est en outre prévu, dans la cavité, des canaux transversaux (24) reliant les deux canaux longitudinaux (23).

5. Dispositif suivant la revendication 4, caractérisé par le fait que des canaux de liaison (26) parallèles aux canaux longitudinaux (23) sont prévus entre les canaux transversaux (24).

6. Dispositif suivant l'une des revendications précédentes, caractérisé par le fait que deux côtés réciproquement opposés (12) du dissipateur de chaleur (1) sont réalisés sous la forme de surfaces de contact pour les composants à semiconducteurs (11) avec lesquels sont établis les contacts.

FIG 1

FIG 2

FIG 3

FIG 4